Europäisches Patentamt

European Patent Office

Office européen des brevets

(19)

(11) Veröffentlichungsnummer: **0 483 593 A2**

# (12) EUROPÄISCHE PATENTANMELDUNG

(21) Anmeldenummer: **91117571.9**

(22) Anmeldetag: **15.10.91**

(51) Int. Cl.5: **G01R 31/02**

(30) Priorität: **31.10.90 DE 4034591**

(43) Veröffentlichungstag der Anmeldung:
**06.05.92 Patentblatt 92/19**

(84) Benannte Vertragsstaaten:
**CH DE FR GB IT LI**

(71) Anmelder: **SIEMENS AKTIENGESELLSCHAFT**
**Wittelsbacherplatz 2**
**W-8000 München 2(DE)**

(72) Erfinder: **Richter, Martin, Dipl.-Ing.(FH)**
**Schulstrasse 20**
**W-8525 Marloffstein(DE)**

(54) **Verfahren und Vorrichtung zum Überprüfen der Isolation von isolierten elektrischen Leitern sowie zur Erkennung und Klassifizierung von Isolationsfehlern.**

(57) Die bisher bekannten und in der Praxis angewandten Verfahren zum Überprüfen der Isolation von isolierten elektrischen Leitern, die wenigstens eine Ader bilden, arbeiten noch nicht zufriedenstellend. Erfindungsgemäß wird ein Verfahren mit folgenden Merkmalen vorgeschlagen:
- Die Ader wird an wenigstens zwei hintereinanderliegende Sonden, die jeweils Kondensatoren mit einem Leiterstück als Gegenpol bilden, vorbeibewegt,
- dabei sind die Sonden derart elektrisch aufgeladen, daß bei Fehlern in der Isolation der Ader der von der einzelnen Sonde und dem jeweiligen Leiterstück gebildete Kondensator von einem Durchschlagstrom kurzgeschlossen wird,
- durch Erfassen der Überschläge an den einzelnen Sonden und deren Auswertung werden jeweils ortsspezifische Signale in Korrelation mit dem Vorschub des Leiters gewonnen,
- durch logische Verknüpfung der ortsspezifischen Signale von den einzelnen Sonden werden Prüfgrößen für die Längenausdehnung der Isolationsfehler abgeleitet.

Bei der zugehörigen Vorrichtung bilden die Sonden voneinander isolierte Teilkondensatoren (11, 12, 13, 14), wobei als Sonden wenigstens zwei Rollen (11, 12; 13, 14) vorhanden sind, die auf gegenüberliegenden Seiten der Ader (1) axial versetzt mit ihren Drehachsen senkrecht zur Bewegungsrichtung der Ader (1) angeordnet sind.

FIG 4

Die Erfindung bezieht sich auf ein Verfahren zum Überprüfen der Isolation von isolierten elektrischen Leitern, die wenigstens eine Ader bilden, sowie zur Erkennung und Klassifizierung von Isolationsfehlern. Daneben bezieht sich die Erfindung auch auf die zugehörige Vorrichtung zur Durchführung des Verfahrens.

Isolierte elektrische Leiter werden in unterschiedlichster Ausbildung und Qualitätsanforderungen benötigt. Derartige Leiter können aus einer einzigen isolierten Ader oder auch mehreren Adern bestehen, die einen gemeinsamen Isolationsmantel haben und somit Kabel oder Leitungen bilden. Hergestellt werden derartige Leitungen üblicherweise durch Extrusion. Bei der Aderextrusion können Fehler in der extrudierten Isolationsschicht auftreten. Zum größten Teil haben derartige Fehler nur die Größe von Poren. Für eine Nachbearbeitung bzw. Reparatur einer Ader ist die Kenntnis einerseits über Fehlerart und Fehlergröße sowie andererseits über deren örtliche Lage von Wichtigkeit.

Es ist bereits üblich, zur Verbesserung der Qualität isolierter elektrischer Leiter und zur Rationalisierung bei der Herstellung die verwendeten Extrusionslinien meßtechnisch auf umfangreiche Weise zu überwachen und zu steuern. Zu den hierfür verwendeten Meßgeräten gehören unter anderem ein sogenannter SPARK-Tester zur Prüfung der Isolierung auf Fehlstellen und ein sogenannter SURFACE-Tester zur Prüfung der Oberfläche des isolierten elektrischen Leiters. Bei den Oberflächenmeßgeräten kann es sich insbesondere um ein Durchmessermeßgerät, um einen sogenannten Knotenwächter oder um ein Oberflächenfehlerprüfgerät handeln.

In der DE-A-38 33 165 wird ein Verfahren zur Erfassung von Isolationsfehlern an kunststoffisolierten elektrischen Leitern beschrieben, bei dem aufgrund einer elektrischen Prüfung der Isolierung einerseits und aufgrund einer Oberflächenprüfung der Isolierung andererseits jeweils ein separates Meßsignal erzeugt und diese Meßsignale ausgewertet werden, wobei das Meßsignal der elektrischen Prüfung und das für denselben Oberflächenabschnitt der Isolierung erzeugte Meßsignal der Oberflächenprüfung einer Logikstufe zugeführt werden, welche die beiden Meßsignale miteinander verknüpft, daß im Falle des Vorhandenseins beider Meßsignale ein zusätzliches Ausgangssignal erzeugt wird.

Weiterhin ist aus der EP-A-O 006 494 ein Verfahren und eine Vorrichtung zum berührungslosen Überprüfen der Isolation bewegter isolierter Leiter bekannt, bei welcher Vorrichtung der Draht axial durch eine ringförmige Sonde geführt wird, die einen Kondensator mit dem Draht als Gegenpol bildet. Ein Isolationsfehler ruft dabei einen elektrischen Überschlag zwischen Sonde und Draht hervor. An die Sonde ist der eine Pol eines Koppelkondensators angeschlossen, der bei Durchschlag auf das Potential des Drahtes gelegt wird. Dadurch entsteht am anderen Pol des Koppelkondensators ein Spannungsimpuls und ein Verschiebestrom, der erfaßt und angezeigt wird.

Mit der älteren, nichtvorveröffentlichten EP-A-O 394 525 wird bereits ein Verfahren letzterer Art vorgeschlagen, bei dem der isolierte elektrische Leiter axial wenigstens zwei hintereinanderliegende ringförmige Sonden, die jeweils Kondensatoren mit dem Leiter als Gegenpol bilden, durchläuft, wobei die Kondensatoren mittels wenigstens einer Spannungsquelle derart aufgeladen werden, daß bei Fehlern in der Isolation der Kondensator von einem Durchschlagstrom kurzgeschlossen wird. Dabei werden durch Erfassen der Überschläge und deren Auswertung an den einzelnen Kondensatoren jeweils ortsspezifische Signale in Korrelation mit dem Vorschub des Leiters gewonnen und durch logische Verknüpfung der ortsspezifischen Signale an den einzelnen Kondensatoren werden Prüfgrößen für die Längenausdehnung der Isolationsfehler abgeleitet.

In praktischer Realisierung bilden bei einer Vorrichtung zur Durchführung dieses Verfahrens die Sonden voneinander isolierte Teilkondensatoren eines Rohrkondensators, die gleiche Länge und in Achsrichtung nur einen geringen Abstand haben, wobei die Teilkondensatoren beim äußeren Ein- bzw. Auslauf des Leiters so geformt sind, daß sich eine gleichbleibende Feldverteilung (Rogowski-Kontur) ergibt.

Aufgabe der Erfindung ist es demgegenüber, ein weiteres Verfahren mit der zugehörigen Vorrichtung anzugeben, mit denen Isolationsfehler mit hinreichender Sicherheit erkannt werden können und Aussagen über Fehlerart und Fehlergröße sowie deren örtliche Lage gemacht werden können.

Letzteres gelingt erfindungsgemäß durch Modifizierung des vorbeschriebenen Verfahrens dadurch, daß das erste Verfahrensmerkmal wie folgt ausgeführt wird:

- Die Ader wird an wenigstens zwei hintereinander liegenden Sonden, die jeweils Kondensatoren mit einem Leiterstück als Gegenpol bilden, vorbeibewegt,
- dabei sind die Sonden derart elektrisch aufgeladen, daß bei Fehlern in der Isolation der Ader der von der einzelnen Sonde und dem jeweiligen Leiterstück gebildete Kondensator von einem Durchlaufstrom kurzgeschlossen wird.

Bei der zugehörigen Vorrichtung sind als Sonden wenigstens zwei Rollen vorhanden, die auf gegenüberliegenden Seiten der Leitung axial versetzt mit ihren Drehachsen senkrecht zur Bewegungsrichtung der Leitung angeordnet sind. Vorzugsweise sind dabei vier Rollen vorhanden, die azimutal versetzt um die zu prüfende Ader angeordnet sind. Von den vier Rollen können jeweils zwei paarweise um 90° verdreht hintereinander auf den gegenüberliegenden Seiten der Ader angeordnet sein.

Das erfindungsgemäße Verfahren unterscheidet sich also von dem vorbeschriebenen Verfahren im wesentlichen dadurch, daß der Leiter nicht berührungsfrei durch eine rohrförmige Sonde hindurch läuft, sondern an rollenförmigen Sonden vorbeiläuft, wobei ein Berühren der Sondenoberfläche bewußt in Kauf genommen wird. Eine Prüfelektrode zur kontinuierlichen Prüfung der Isolierung eines abgezogenen isolierten elektrischen Leiters in Ausbildung speziell als Rolle ist an sich aus der DE-A-24 35 727 bekannt. Die Funktion des Rollenumfanges als Führungsstrecke beim Durchlaufen einer Leitung zwischen wenigstens zwei Kondensatorelektroden bildenden Rollen ist dort aber nicht angesprochen.

Bei geeigneter Ausbildung der Oberflächenkontur der Rollen als weitgehend halbkreisförmiges Profil ist bei schnellem Durchlauf die Berührung der Rolle nicht hinderlich. Vorteilhaft ist in jedem Fall, daß durch den geringen Abstand von Elektrode und Leitung nunmehr mit vergleichsweise kleinen Spannungen zum Aufladen des so gebildeten Kondensators bzw. für einen Durchschlag bei Isolationsfehlern gearbeitet werden kann. Dadurch wird die Lokalisierung der Überschläge wesentlich genauer. Vor- bzw. Nachzündungen können damit weitgehend ausgeschlossen werden und brauchen nicht mehr durch logische Signalverarbeitung erkannt und eliminiert werden.

Dagegen bleiben die bei dem vorbeschriebenen Verfahren bereits herausgestellten Vorteile voll erhalten: In vorteilhafter Weise sind die Längenausdehnung der Isolationsfehler hinsichtlich Porenfehler ohne Ausdehnung, kurze Fehler mit Ausdehnungen $D<1_F<3mm$ und lange Fehler mit Ausdehnungen $3mm <1_F < \infty$ diskriminierbar. Darüberhinaus können Flächenausdehnungen der Isolationsfehler hinsichtlich der einer Berührung zugänglichen Blankstellen diskriminiert werden. Nunmehr wird zusätzlich die Querausdehnung einer Isolation der Leiteroberfläche selbst erkennbar.

Insbesondere bei Verwendung von vier Rollen als Kondensatorelektroden und Speicherung der während des Durchlaufs eines Isolationsfehlers auftretenden Überschläge in jedem Kondensatorteil kann aus der Konstellation der teilebezogenen Überschläge die tatsächliche Fehlerlänge und/oder Fehlerlage bestimmt und längenzugeordnet angezeigt werden. Die Rollenelektrode mit der größten wegbezogenen Überschlagslänge gibt die tatsächliche Fehlerlänge an.

Bei der erfindungsgemäßen Vorrichtung ist vorteilhafterweise ein Personalcomputer (PC) mit zugehörigen Endgeräten vorhanden. Durch geeignete softwaremäßige Ablaufsteuerung können nach Ermittlung, Diskriminierung und Anzeige des jeweiligen Isolationsfehlers durch Rückkopplung der Daten zum Umwickelstand die zu reparierenden Fehlstellen automatisch aufgefunden werden, so daß der Umwickelstand gleichzeitig als Reparaturstand fungiert.

Weitere Einzelheiten und Vorteile der Erfindung ergeben sich aus der nachfolgenden Figurenbeschreibung eines Ausführungsbeispiels. Es zeigen

FIG 1 einen isolierten elektrischen Leiter im Seitenriß und typischen Querschnitten zur Verdeutlichung der unterschiedlichen Fehlertypen,

FIG 2 eine aus vier Rollen aufgebaute Sondenanordnung mit daran vorbeilaufender Leitung in Seitenansicht,

FIG 3 eine Prinzipdarstellung zur Verdeutlichung von FIG 2,

FIG 4 den Aufbau der Sondenanordnung gemäß FIG 2 zusammen mit den Einheiten zur Spannungsversorgung und Meßwerterfassung und

FIG 5 als Blockschaltbild die Einheiten zum Zählen und Zwischenspeichern der ortsspezifischen Signale zusammen mit den zugehörigen Auswertemitteln.

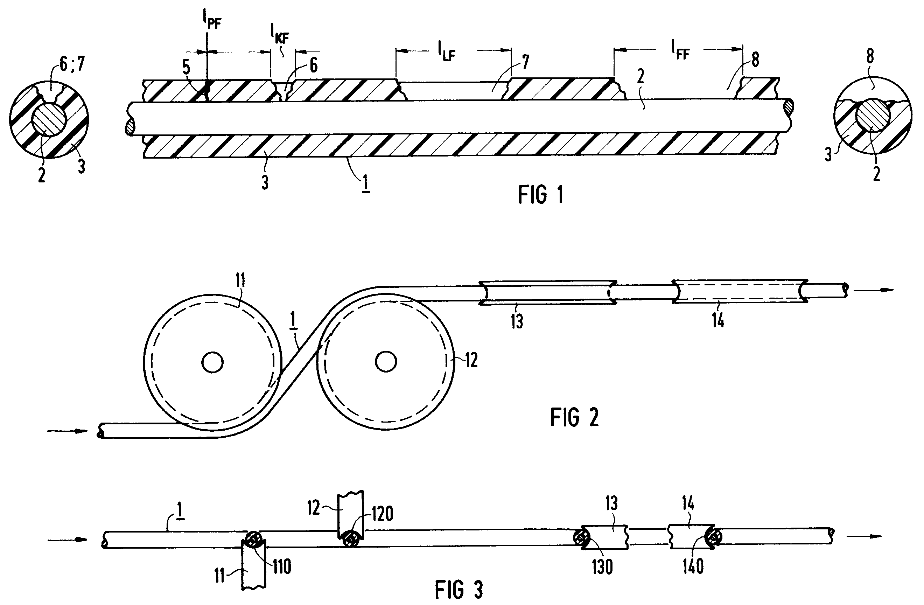

In FIG 1 ist eine Ader 1 aus einem isolierten elektrischen Leiter dargestellt, die aus dem eigentlichen metallischen Draht 2 als Leiter und der Isolationsschicht 3 besteht. Derartige Leitungen können in unterschiedlicher Weise je nach den entsprechenden Anforderungen ausgestaltet sein. Beispielsweise kann es sich um eine einzige Ader handeln, wie in FIG 1 dargestellt; es können auch mehrere Adern, die jeweils aus einem isolierten elektrischen Leiter bestehen, zu einer mehradrigen Leitung verdrillt und mit einer gemeinsamen Isolationsschicht versehen sein.

Die Herstellung derartiger Leitungen erfolgt durch Aufextrusion von Isoliermaterial auf den metallischen Draht. Die Isoliermaterialien können Silikongummi und/oder Kunststoffe sein und sind auf die spezifischen Anforderungen bei der späteren Verwendung der Leitung abgestellt.

In FIG 1 ist ein Porenfehler 5 vorhanden, der an der Oberfläche praktisch keine Ausdehnung hat, aber einen Strompfad zum metallischen Leiter 2 realisiert. Ein sogenannter "Kurzer Fehler" 6 hat eine vorgegebene maximale Längsausdehnung als Obergrenze, die im vorliegenden Fall mit 3 mm definiert ist. Längere Fehler, wie beispielsweise Fehler 7 in FIG 1, werden als sogenannte "Lange Fehler" definiert. Dabei wird zunächst nur die axiale Ausdehnung des Isolationsfehlers betrachtet.

Letztere Isolationsfehler können unterschiedliche geometrische Ausformungen radial zum metallischen Leiter haben, was im Schnittbild angedeutet ist. Weiterhin können die kurzen Fehler 6 (KF) und die langen Fehler 7 (LF) neben der axialen Ausdehnung auch eine Ausdehnung azimutal über den Umfang des Leiters haben. Die Länge und die Querausdehnung des Fehlers auf der Leiteroberfläche ist maßgeblich für die einer Berührung zugängliche Blankstelle. Eine solche Blankstelle ist in FIG 1 mit 8 angedeutet und wird als Flächenfehler (FF) bezeichnet.

Gemäß VDE-Vorschriften (VDE 0472, Teil 514) müssen Kabel und isolierte Leitungen auf Fehler in der Isolierhülle geprüft werden. Dabei wird gefordert, daß alle potentiellen Fehler von einer diesbezüglichen Prüfeinrichtung registriert werden, was sich jedoch bei einem Durchlaufverfahren wegen der Erholzeiten der bekannten Prüfgeräte als schwierig erweist, wenn beispielsweise zwei Fehler bei schnellem Durchlauf der Leitung durch eine Sonde in geringem Abstand hintereinander auftreten.

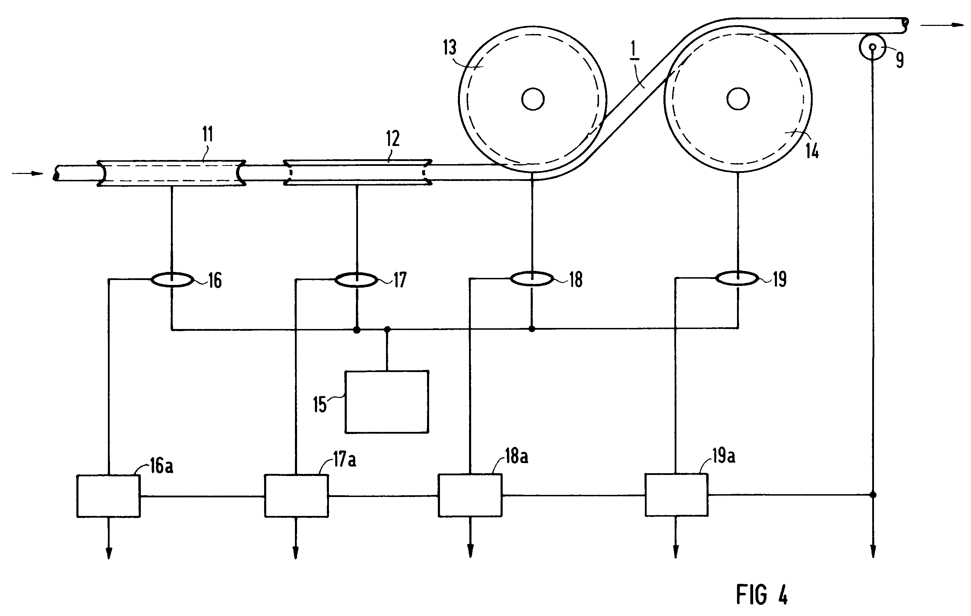

In FIG 2 und FIG 3 läuft die Leitung 1 an vier Rollen 11, 12, 13 und 14 vorbei, wobei die Rollen 11 bis 14 derart angeordnet sind, daß der gesamte Leitungsumfang mit entsprechender Überlappung abgedeckt ist. Konkret sind jeweils zwei Rollen 11 und 12 bzw. 13 und 14 axial versetzt einander gegenüberliegend angeordnet, so daß zwischen beiden die Leitung 1 hindurchlaufen kann. Im einfachsten Fall können zwei Rollen 11 und 12 bzw. 13 und 14 bereits hinreichend sein. Besonders günstig ist aber eine Konstellation aus vier Rollen 11 bis 14, wenn zwei Rollen 11 und 12 sowie 13 und 14 jeweils paarweise um 90° gedreht angeordnet sind.

Die Rollen 11 bis 14 bestehen gewöhnlich aus Messing und bilden mit ihrem Umfang eine Rille, in der die Leitung 1 schlupffrei hindurchlaufen kann. Zweckmäßigerweise haben die Rollen 11 bis 14 am Umfang einen Einsatz aus Isoliermaterial, das nur eine metallisierte Laufrille besitzt, um die Eigenkapazität gegen Masse zu minimieren und den Aufladevorgang zu beschleunigen. Die Laufrillen werden jeweils durch im wesentlichen halbkreisförmige Konturen 110, 120, 130 oder 140 am Umfang der Rollen 11 bis 14 geformt. Es empfiehlt sich, die halbkreisförmigen Konturen 110 bis 140 an den Seitenkanten abzuflachen oder abzurunden, um Feldkonzentrationen zu vermeiden.

In FIG 4 durchläuft die Leitung 1 aus FIG 1 eine Anordnung 10, die aus den vier Rollen 11 bis 14 der FIG 2 und 3 besteht. Alle Rollen 11 bis 14 den gleichen Durchmesser, der zwischen 50 und 500 mm liegen kann. Sie sind voneinander isoliert aufgebaut und haben zueinander in Aderlaufrichtung nur einen geringen Abstand, damit sie vom selben Hochspannungsgenerator 15, beispielsweise mit 7 kHz und einer Spannung von 5 KV gespeist werden können.

Die Versorgungsleitungen der als Kondensatorelektroden dienen den Rollen 11 bis 14 werden mittels HF-Stromwandler 16 bis 19 auf Stromfluß überwacht. Die Stromwandler 16 bis 19 sind vorteilhafterweise durch ringförmige Ferritkerne mit Wicklung realisiert, in die bei Stromfluß Spannungen induziert werden und denen jeweils Pulsformerstufen 16a bis 19a nachgeschaltet sind. Dadurch steht im Fall eines elektrischen Überschlages, der bei einem Fehler in der Leitung 1 von der spannungführenden Kondensatorelektrode hervorgerufen wird, jeweils ein Signal zur Verfügung, das elektronisch weiterverarbeitet werden kann. Gleichzeitig gibt ein Längenimpulsgeber 9, beispielsweise als Millimeterrad, im Abstand von 1 mm inkrementale Zählimpulse ab, wodurch eine ortsbezogene Speicherung der Überschläge möglich wird.

Wenn eine Leitung 1 durch die Anordnung 10 mit hoher Geschwindigkeit läuft, werden bei Vorliegen von Isolationsfehlern nacheinander bzw. parallel Überschläge von den einzelnen Rollenelektroden 11, 12, 13 und 14 zur Leitung 1 auftreten. Dabei werden bei einem Porenfehler im Idealfall bei Durchlauf der Leitung 1 durch die Anordnung 10 Überschläge zunächst nur an der ersten Rolle 11 und anschließend an der dritten Rolle 13 oder zunächst nur an der zweiten Rolle 12 und anschließend an der vierten Rolle 14 auftreten, da jeweils ein Halbraum abgedeckt ist. Bei linienhaft ausgedehnten Isolationsfehlern, können gleichzeitig Überschläge an zwei einander anschließende Rollen 11 und 12 bzw. 13 und 14 auftreten.

Im praktischen Betrieb kann es allerdings durch Nässe oder dergleichen beispielsweise zum Vorzünden und/oder zum Nachzünden kommen, so daß auch bei Porenfehlern nacheinander Überschläge an den Teilkondensatoren auftreten können. Weiterhin kann es auch zu Zündaussetzern kommen, bei denen ein Überschlag oder mehrere eigentlich zu erwartende Überschläge nicht auftreten. Bei Auftreten derartiger Artefakte ergeben sich daraus erhebliche Abweichungen vom Idealzustand. Es ergeben sich jeweils ganz spezifische Muster für unterschiedlichste Fehlerkonstellationen, die aber mittels eines Rechners durch logische Verknüpfungen erfaßbar und den einzelnen Fehlerarten zuordbar sind.

Aufgrund der unterschiedlichen Muster kann eindeutig zwischen Porenfehlern (PF) einerseits und kurzen Fehlern (KF) sowie langen Fehlern (LF) andererseits und der bei letzteren Fehlern möglicherweise auftretenden Blankstellen unterschieden werden. Daneben kann die Fehlerfolge bzw. der Fehlerfolgeabstand erfaßt werden.

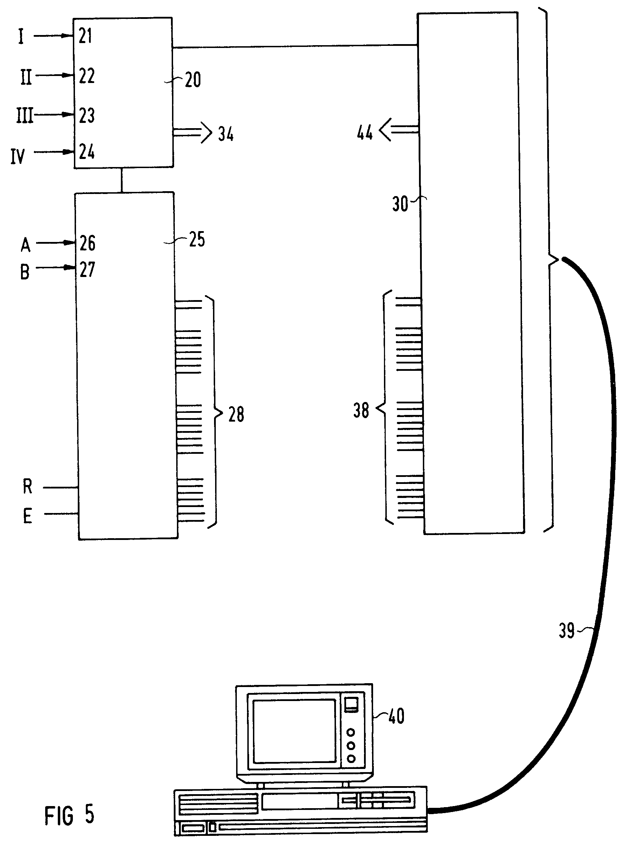

In FIG 5 ist ein erster Speicher 20 mit Eingängen 21 bis 24 für Überschläge I, II, III und IV vorhanden, dem ein üblicher 26-Bit-Zähler 25 für Zählimpulse A und B zugeordnet ist und dem ein zweiter 32-Bit-Speicher 30 mit 16 K Tiefe nachgeschaltet ist. Es sind einerseits Mittel 34 bzw. 44 für eine Elektrodenkennung sowie andererseits Mittel 28 und 38 für eine 26-Bit-Positionscodierung vorhanden. Der Speicher 30 ist über einen Lichtwellenleiter 39 mit einem Personal-Computer 40 verbunden, der zur Auswertung der Signale und Steuerung eines eventuellen Reparaturvorganges dient.

Die Zählimpulse des Millimeterrades 9 aus FIG 4 werden auf den Zähler 25 geleitet, der mit 26 Bit eine Aderlänge von über 60 km in Millimeterschritten aufnehmen kann. Die Triggersignale der Stromwandler 16 bis 19 für die einzelnen Rollen 11 bis 14 gemäß FIG 2 und 3 gehen zunächst auf die Zwischenspeicherstufe 20, die gewährleistet, daß Mehrfachüberschläge innerhalb eines Längenschrittes nur einmal bewertet werden. Jeweils beim Weiterschalten zum nächsten Schritt wird der Inhalt des Speichers 20 mit den eventuellen Überschlagsereignissen in den Speicher 30 übertragen und unter der jeweiligen Schrittnummer abgelegt. Im Speicher 30 können in Abhängigkeit von der Dimensionierung der Rollen 11 bis 13, beispielsweise bei vorgegebenen Berührwinkel und Durchmesser entsprechend einer Berührlänge von 20 mm, insgesamt 16 m fehlerhafte Ader entsprechend einer blanken Ader oder 800 verschiedene Porenfehler der Leitung 1 abgespeichert werden.

Die gespeicherten Informationen werden mittels des Lichtwellenleiters 39 zum Personalcomputer 40 übertragen und dort ausgewertet. Von hier kommt unmittelbar nach Beendigung des Fertigungsvorganges ein optisches Signal, ob und gegebenenfalls welche Art von Fehlern in der Isolierhülle gemäß VDE 0472, Teil 514 bei der gefertigten Trommel vorliegen und ob diese zum Umwikkelstand muß, um dort repariert zu werden. Dabei steuert der PC 40 gleichermaßen das Rückwickeln der Trommel bis zum lokalisierten Fehler.

Durch die parallele Erfassung der Überschläge lassen sich die unterschiedlichen Fehler diskriminieren. Es läßt sich näherungsweise folgende Beziehung angeben:

$$\Delta 1_F = n - (k + 1_s) \pm 1$$

wobei $\Delta 1_F$ die Längenausdehnung des Fehlers in mm, n eine Folge von Längenschritten, bei der in einem der Teilkondensatoren 11 bis 13 ein Überschlag stattfand, k die Ausdehnung der Berührstrecke in Längenschritten und $1_s$ ein diskreter Längenschritt bedeuten. Die Toleranzabweichung von ± 1 ergibt bei vier Teilkondensatoren auf jeden Fall eine eindeutige Diskriminierung aller unterschiedlichen Fehlerarten.

Praktische Untersuchungen haben ergeben, daß sich mit der Vorrichtung gemäß FIG 4 in Verbindung mit der Auswerteeinheit gemäß FIG 5 die in der Praxis relevanten Fehler diskriminieren lassen. Es ist dafür Sorge getragen, daß pro Längenschritt alle Überschläge erfaßt und registriert werden, wobei mindestens jeweils ein Überschlag ortsspezifisch ausgewertet wird. Durch die entsprechende softwaremäßige Auswertung aller von den Rollen nacheinander oder auch gleichzeitig anfallender Überschlagssignale im Personalcomputer 40 können Fehldeutungen ausgeschaltet werden.

Darüber hinaus können durch die paarweise um 90° gedrehten Rollen 11 bis 14 und jeweilige Zuordnung eines Halbraumes auch an der Leiteroberfläche azimutal ausgedehnte Fehler, die gegebenenfalls eine Blankstelle realisieren, erkannt werden. Die noch erlaubte Zugänglichkeit einer solchen Blankstelle ist durch die VDE-Richtlinien definiert und kann durch die softwaremäßige Verknüpfung der Einzelsignale diskriminiert werden.

**Patentansprüche**

1. Verfahren zum Überprüfen der Isolation von isolierten elektrischen Leitern, die wenigstens eine Ader bilden, sowie zur Erkennung und Klassifizierung von Isolationsfehlern mit folgenden Verfahrensmerkmalen:
   - Die Ader wird an wenigstens zwei hintereinanderliegenden Sonden, die jeweils Kondensatoren mit einem Leiterstück als Gegenpol bilden, vorbeibewegt,
   - dabei sind die Sonden derart elektrisch aufgeladen, daß bei Fehlern in der Isolation der Ader der von der einzelnen Sonde und dem jeweiligen Leiterstück gebildete Kondensator von einem Durchschlagstrom kurzgeschlossen wird,
   - durch Erfassen der Überschläge an den einzelnen Sonden und deren Auswertung werden jeweils ortsspezifische Signale in Korrelation mit dem Vorschub der Ader gewonnen,
   - durch logische Verknüpfung der ortsspezifischen Signale von den einzelnen Sonden werden Prüfgrößen für die Längenausdehnung der Isolationsfehler abgeleitet.

2. Verfahren nach Anspruch 1, **dadurch gekennzeichnet**, daß die Längenausdehnungen der Isolationsfehler hinsichtlich Porenfehler ohne Ausdehnung (PF), kurze Fehler (KF) mit Ausdehnungen $0<1_F<3mm$ und lange Fehler (LF) mit Ausdehnungen $3mm<1_F<\infty$ diskriminiert werden.

3. Verfahren nach Anspruch 1, **dadurch gekennzeichnet,** daß auch die Querausdehnungen der Isolationsfehler an der Leiteroberfläche diskriminiert werden.

4. Verfahren nach Anspruch 1 und 3, **dadurch gekennzeichnet,** daß die Längsausdehnungen und die Querausdehnungen der Isolationsfehler zusammen hinsichtlich der einer Berührung zugänglichen Blankstellen diskriminiert werden.

5. Verfahren nach Anspruch 1 und 2, **dadurch gekennzeichnet,** daß pro Längenschritt alle Überschläge an den Sonden erfaßt und registriert werden, wobei mindestens jeweils ein Überschlag ortsspezifisch ausgewertet wird.

6. Verfahren nach Anspruch 1, **dadurch gekennzeichnet**, daß eine ortsbezogene Speicherung der Isolationsfehler durch Abspeicherung von Überschlagimpulsen auf einem Zähler und Zuordnung der Isolationsfehler zu Weg-/Längen-Schritten erfolgt.

7. Verfahren nach Anspruch 1, **dadurch gekennzeichnet**, daß von den einzelnen Sonden bei Auftreten eines Überschlages Triggersignale auf eine Zwischenspeicherstufe gegeben werden.

8. Verfahren nach Anspruch 7, **dadurch gekennzeichnet**, daß in der Zwischenspeicherstufe eine Synchronisation der Prüfsignale der einzelnen Sonden in der Weise erfolgt, daß mehrfach Überschläge innerhalb eines Längenschrittes nur einmal bewertet werden.

9. Verfahren nach Anspruch 7 und 8, **dadurch gekennzeichnet**, daß mit jedem Längenschritt der Speicherinhalt vom Zwischenspeicher in einen Fehlerspeicher übertragen und dort unter dem zugehörigen Längenschritt abgespeichert wird.

10. Verfahren nach Anspruch 9, **dadurch gekennzeichnet**, daß die im Speicher gespeicherten Informationen in einen Personalcomputer übermittelt und dort ausgewertet werden.

11. Verfahren nach Anspruch 2 und 10, **dadurch gekennzeichnet**, daß bei Erkennen von langen Fehlern (LF) der Fertigungsvorgang unterbrochen und der Leitungswickel rechnergesteuert zum Fehlerort zwecks Reparatur zurückgespult werden.

12. Vorrichtung zur Durchführung des Verfahrens nach Anspruch 1 oder einem der Ansprüche 2 bis 11, bei der ein sich in axialer Richtung bewegender isolierter elektrischer Leiter, der wenigstens eine Ader bildet, von wenigstens zwei Sonden, die als Kondensator mit dem Leiter als Gegenpol geschaltet und mit einer Hochspannungsquelle verbunden sind, detektiert wird, **dadurch gekennzeichnet**, daß als Sonden wenigstens zwei Rollen (11,12,13,14) vorhanden sind, die auf gegenüberliegenden Seiten der Ader (1) axial versetzt mit ihren Drehachsen senkrecht zur Bewegungsrichtung der Ader (1) angeordnet sind.

13. Vorrichtung nach Anspruch 12, **dadurch gekennzeichnet,** daß vier Rollen (11 bis 14) vorhanden sind, die azimutal versetzt um die zu prüfende Ader (1) angeordnet sind.

14. Vorrichtung nach Anspruch 13, **dadurch gekennkennzeichnet,** daß von den vier Rollen (11 bis 14) jeweils zwei (11, 12 bzw. 13, 14) paarweise um 90° verdreht hintereinander auf den gegenüberliegenden Seiten der Ader (1) angeordnet sind.

15. Vorrichtung nach Anspruch 12, **dadurch gekennzeichnet,** daß am Umfang der Rollen (11 bis 14) eine Rille mit in etwa halbkreisförmigem Profil (110, 120, 130, 140) gebildet ist, in der die Ader (1) läuft.

16. Vorrichtung nach Anspruch 15, **dadurch gekennzeichnet,** daß das halbkreisförmige Profil (110, 120, 130, 140) an den Kanten der Rollen (11 bis 14) abgeflacht, insbesondere abgerundet, ist.

17. Vorrichtung nach Anspruch 12, 13 oder 14, **dadurch gekennzeichnet**, daß ein einziger Hochspannungsgenerator (15) mit Anschlußleitungen als Spannungsquelle für die durch die Rollen (11,12,13,14) gebildeten Kondensatorelektroden dient und daß in die Anschlußleitungen der Kondensatoren HF-Stromwandler (16 bis 19) geschaltet sind.

18. Vorrichtung nach Anspruch 17, **dadurch gekennzeichnet,** daß die HF-Stromwandler (16 bis 19) ringförmige drahtbewickelte Ferritkerne sind, denen jeweils eine Pulsformstufe (16a bis 19a) nachgeschaltet ist.

19. Vorrichtung nach Anspruch 12 oder 13, **dadurch gekennzeichnet**, daß jeder Rolle (11, 12, 13, 14) ein eigener Hochspannungsgenerator zugeordnet ist.

20. Vorrichtung nach Anspruch 12, **dadurch gekennzeichnet**, daß ein Längenimpulsgeber (29) vorhanden ist, der im Abstand 0,1 mm $\leq$ $1_s \leq$ 1 mm inkrementale Zählimpulse abgibt, die auf einen digitalen Zähler (25), vorzugsweise einen 26 Bit-Zähler, geleitet werden.

21. Vorrichtung nach Anspruch 12, **dadurch gekennzeichnet**, daß ein erster Speicher (20), der als Zwischenspeicherstufe für die Triggersignale und deren Synchronisation dient, und ein zweiter Speicher (30) für die positionsgenaue Abspeicherung der Triggersignale vorhanden sind.

22. Vorrichtung nach Anspruch 21, **dadurch gekennzeichnet**, daß die Speicher (20, 30) über einen Lichtwellenleiter (39) an einen Personalcomputer (40) angekoppelt sind.

23. Vorrichtung nach Anspruch 22, **dadurch gekennzeichnet**, daß der Personalcomputer (40) zur Diskriminierung und Anzeige der Isolationsfehler programmiert ist sowie gleichermaßen einen Reparatur- und Umwickelstand für die Ader (1) bei Vorliegen eines Isolationsfehlers steuert.

FIG 1

FIG 2

FIG 3

FIG 4

FIG 5